# EUROPEAN PATENT APPLICATION

(11) **EP 0 899 877 A1**
(43) Date of publication of application: **03.03.1999**
(21) Application number: 98306493.2
(22) Date of filing: 14.08.1998
(51) Int. Cl.: H03J 5/24

(54) **IC for tuner**

(30) Priority: 01.09.1997 JP 236101/97
(71) Applicant: ALPS ELECTRIC CO., LTD., Ota-ku Tokyo 145 (JP)
(72) Inventor: Yamamoto, Masaki, Futaba-gun, Fukushima-ken (JP); Sato, Yoshihiro, Soma-shi, Fukushima-ken (JP)
(74) Representative: Kensett, John Hinton

(57) **Abstract**

Described herein is an IC suitable for use in a tuner. In the IC, respective major circuit portions in a frequency mixer circuit, a local oscillator circuit, a phase locked loop (PLL), and an intermediate frequency amplifier circuit are integrally placed within one package. A UHF selection terminal, UHF signal input terminals, a VHF signal input terminal, a high-frequency ground terminal, frequency mixed signal output terminals, VHF band selection terminals, a power terminal and intermediate frequency input terminals are drawn or led out to one end of the package, which is located on the side of the long side thereof, in this order.

## Description

This invention relates to an IC suitable for use in a tuner, and particularly to an IC suitable for use in a tuner, wherein respective terminals led out from a package are led out and disposed so that wires or interconnections do not intersect each other on a wiring board for a UHF-VHF tuner, which is equipped with the tuner IC.

### Description of the Related Art:

In a UHF-VHF tuner, a tuner IC of a type wherein respective major circuit portions (corresponding to integrable circuit portions) in a frequency mixer circuit, a local oscillator circuit, a phase locked loop (PLL) and an intermediate frequency amplifier circuit are integrally or collectively placed within one package, has heretofore been built in a tuner wiring board. Further, non-integrated circuit portions in the respective circuits, e.g., circuit portions including inductance, capacitance, etc. have been respectively disposed around the tuner IC and electrically connected to their corresponding terminals of the tuner IC.

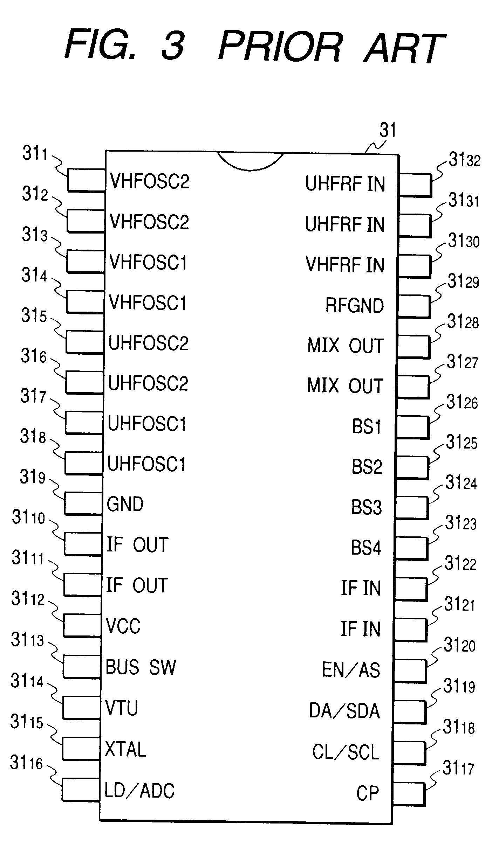

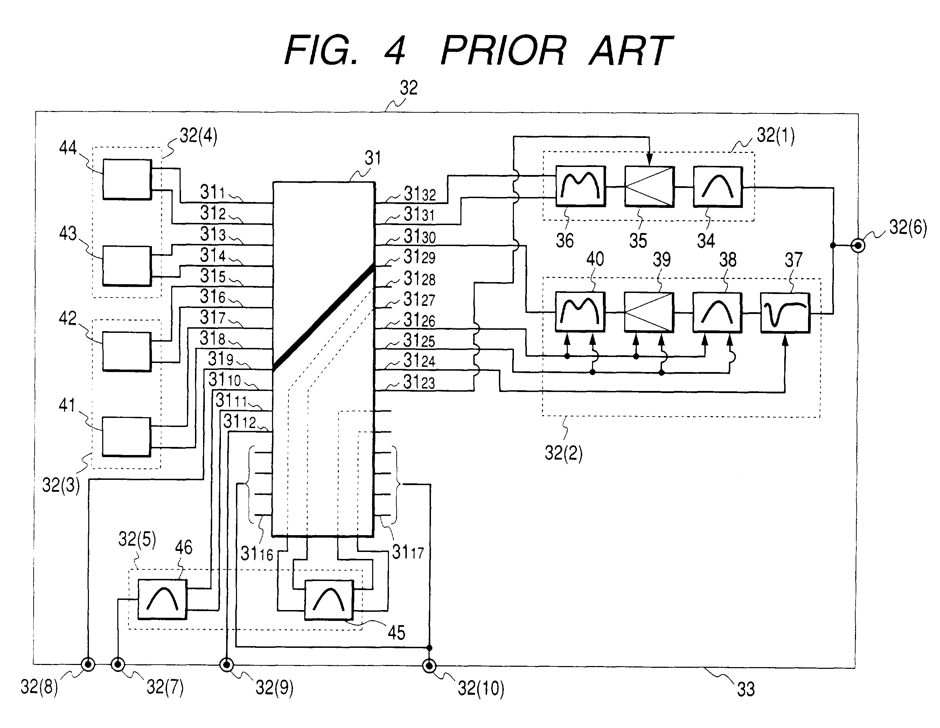

Now, FIG. 3 is a plan view showing one example of a configuration of the already-known tuner IC. FIG. 4 is a plan view illustrating one example of a layout of a UHF-VHF tuner wiring board with the tuner IC illustrated in FIG. 3 built therein.

As shown in FIG. 3, the known tuner IC31 is shaped in the form of a rectangle. Sixteen terminals (connecting pins) 31₁ through 31₁₆ are drawn or led out to one end thereof located on the side of the long side of the tuner IC31. Sixteen terminals (connecting pins) 31₁₇ through 31₃₂ are drawn or led out to the other end thereof located on the side of the long side thereof. Of these terminals 31₁ through 31₁₆ and 31₁₇ through 31₃₂, the terminals 31₁ and 31₂ are second VHF local oscillator terminals (VHF OSC2), the terminal 31₃ and 31₄ are first VHF local oscillator terminal (VHF OSC1), the terminals 31₅ and 31₆ are second UHF local oscillator terminals (UHF OSC2), the terminals 31₇ and 31₈ are first UHF local oscillator terminals (UHF OSC1), the terminal 31₉ is a ground terminal (GND), the terminals 31₁₀ and 31₁₁ are intermediate frequency signal output terminals (IF OUT), and the terminal 31₁₂ is a power terminal (Vcc). Further, the terminals 31₁₃ through 31₂₀ are respectively PLL data terminals (BUS SW, VTU, XTAL, LD/ADC, CP, CL/SCL, DA/SDA and EN/AS). The terminals 31₂₁ and 31₂₂ are intermediate frequency signal input terminals (IF IN), the terminal 31₂₃ is a UHF selection terminal (BS4), the terminal 31₂₄ is an FM trap selection terminal (BS3), the terminals 31₂₅ and 31₂₆ are VHF band selection terminals (BS2, BS1), the terminals 31₂₇ and 31₂₈ are mixer output terminals (MIX OUT), the terminal 31₂₉ is a high-frequency ground terminal (RF GND), the terminal 31₃₀ is a VHF signal input terminal (VHF RF IN), and the terminals 31₃₁ and 31₃₂ are UHF signal input terminals (UHF RF IN).

As shown in FIG. 4, a tuner wiring board 32 is stored and placed within an enclosure or package 33. The tuner IC31 is built in the tuner wiring board 32. A UHF signal circuit unit 32a comprised of a UHF signal antenna tuning circuit 34, a UHF signal amplifier circuit 35 and a UHF signal double-tuned circuit 36, a VHF signal circuit unit 32b comprised of an FM signal trap circuit 37, a VHF signal antenna tuning circuit 38, a VHF signal amplifier circuit 39 and a VHF signal double-tuned circuit 40, a UHF local oscillator circuit unit 32c comprised of a first UHF local oscillator circuit 41 and a second UHF local oscillator circuit 42, a VHF local oscillator circuit unit 32d comprised of a first VHF local oscillator circuit 43 and a second VHF local oscillator circuit 44, and an intermediate frequency signal circuit unit 32e comprised of a first intermediate frequency tuning circuit 45 and a second intermediate frequency tuning circuit 46 are respectively placed within the tuner wiring board 32.

Further, a received signal port 32f supplied with received signals from an antenna (not shown), an intermediate frequency signal port 32g for outputting an intermediate frequency signal therefrom, a ground port 32h electrically connected to ground, a power supply port 32i supplied with a power supply voltage, and a PLL data port 32j for exchanging various data between a PLL in the tuner IC31 and an externally-provided microcomputer (not shown) are provided around the tuner wiring board 32.

The respective terminals 3₁₁ through 31₃₂ of the tuner IC31 and the respective circuits 34 through 44 in the tuner wiring board 32, and the respective circuits 34 through 44 and the respective ports 32f through 32j are respectively connected to one another as shown in FIG. 4. In this case, input terminals of the first intermediate frequency tuning circuit 45 and the mixer output terminals 31₂₇ and 31₂₈, and output terminals of the first intermediate frequency tuning circuit 45 and the intermediate frequency signal input terminals 31₂₁ and 31₂₂ are connected to one another so that some of wires or interconnections used for connection between the former two and some of interconnections used for connection between the latter two pass through the side under the tuner IC31 as indicated by dotted lines, respectively.

The known UHF-VHF tuner constructed as described above, is activated as follows:

When the UHF-VHF tuner is first selected so as to receive a UHF signal, a positive voltage is outputted from the UHF selection terminal 31₂₃ of the tuner IC31 and thereafter supplied to the UHF signal amplifier circuit 35, so that the UHF signal amplifier circuit 35 is brought to an operating state. At this time, the UHF signal supplied to the received signal port 32f passes through the UHF signal antenna tuning circuit 34, the UHF signal amplifier circuit 35 and the UHF signal double-tuned circuit 36 so that a signal for a desired channel is selected, followed by supply to the UHF signal input terminals 31₃₁ and 31₃₂ of the tuner IC31. The tuner IC31 frequency-mixes the supplied signal and a local oscillation signal generated from a first UHF local oscillator (or second local oscillator) by a frequency mixer and outputs the resultant mixed signal from the mixer output terminals 31₂₇ and 31₂₈. Next, the first intermediate frequency tuning circuit 45 selects an intermediate frequency signal from the frequency-mixed signal and supplies it to the intermediate frequency signal input terminals 31₂₁ and 31₂₂ of the tuner IC31. The tuner IC31 amplifies the intermediate frequency signal to a predetermined level by using the intermediate frequency amplifier circuit and outputs the amplified intermediate frequency signal from the intermediate frequency signal output terminals 31₁₀ and 31₁₁. Subsequently to this, the second intermediate frequency tuning circuit 46 removes unnecessary frequency components from the intermediate frequency signal and thereafter supplies the so-processed signal to the intermediate frequency signal port 32g.

Next, when the UHF-VHF tuner is selected so as to receive a VHF high-band signal, a positive voltage is outputted from the VHF band selection terminal 31₂₅ of the tuner IC31. The positive voltage is supplied to the VHF signal amplifier circuit 39 so that the VHF signal amplifier circuit 39 is brought to an operating state. Further, the positive voltage is supplied to the VHF signal antenna tuning circuit 38 and the VHF signal double-tuned circuit 40 to change these tuning circuits 38 and 40, thereby switching them to a state capable of receiving the VHF high-band signal. At this time, the VHF high-band signal supplied to the received signal port 32f is transmitted through the FM signal trap circuit 37 substantially set to a non-loss state, the VHF signal antenna tuning circuit 38, the VHF signal amplifier circuit 39 and the VHF signal double-tuned circuit 40 so that a signal for a desired channel is selected, followed by supply to the VHF signal input terminal 31₃₀ of the tuner IC31. The tuner IC31 frequency-mixes the supplied signal and a local oscillation signal generated from the first VHF local oscillator (or second local oscillator) by the frequency mixer and outputs the resultant frequency-mixed signal from the mixer output terminals 31₂₇ and 31₂₈. Next, the first intermediate frequency tuning circuit 45 selects an intermediate frequency signal from the mixed signal and supplies the selected intermediate frequency signal to the intermediate frequency signal input terminals 31₂₁ and 31₂₂ of the tuner IC31. The tuner IC31 amplifies the intermediate frequency signal to a predetermined level by the intermediate frequency amplifier circuit and outputs the amplified intermediate frequency signal from the intermediate frequency signal output terminals 31₁₀ and 31₁₁. Consecutively, the second intermediate frequency tuning circuit 46 removes unnecessary frequency components from the intermediate frequency signal and thereafter supplies the so-processed signal to the intermediate frequency signal port 32g.

Subsequently, when the UHF-VHF tuner is selected so as to receive a VHF low-band signal, a positive voltage is outputted from the VHF band selection terminal 31₂₆ of the tuner IC31. The positive voltage is supplied to the VHF signal amplifier circuit 39 so that the VHF signal amplifier circuit 39 is brought to an operating state. Further, the positive voltage is supplied to the VHF signal antenna tuning circuit 38 and the VHF signal double-tuned circuit 40 to change these circuits 38 and 40, thereby switching them to a state capable of receiving the VHF low-band signal. Only when the tuner IC31 now selects channels of VHF low-band signal channels, which are adjacent to an FM-radio broadcast carrier frequency and undergo interference of its carrier frequency, e.g., 6 channels (hereinafter called "non-interfered channels") for US television broadcasting, a positive voltage is outputted from the FM trap selection terminal 31₂₄. The positive voltage is supplied to the FM signal trap circuit 37 to bring the FM signal trap circuit 37 into an operating state, thereby attenuating FM-radio broadcast carrier frequency components. Therefore, when the respective channels other than the non-interfered channels are received, the VHF low-band signal supplied to the received signal port 32f passes through the FM signal trap circuit 37 substantially set to the non-loss state, the VHF signal antenna tuning circuit 38, the VHF signal amplifier circuit 39 and the VHF signal double-tuned circuit 40 so as to select a signal for a desired channel, which is followed by supply to the VHF signal input terminal 31₃₀ of the tuner IC31. On the other hand, when the non-interfered channels are received, the FM signal trap circuit 37 removes interference frequency components from the non-interfered channel signal supplied to the received signal port 32f. Thereafter, the so-processed signal passes through the VHF signal antenna tuning circuit 38, the VHF signal amplifier circuit 39 and the VHF signal double-tuned circuit 40 and is supplied to the VHF signal input terminal 31₃₀ of the tuner IC31 in the same manner. The tuner IC31 frequency-mixes the supplied signal and a local oscillation signal generated from the first VHF local oscillator (or second local oscillator) by the frequency mixer and outputs the resultant mixed signal from the mixer output terminals 31₂₇ and 31₂₈. Next, the first intermediate frequency tuning circuit 45 selects an intermediate frequency signal from the frequency-mixed signal and supplies the selected intermediate frequency signal to the intermediate frequency signal input terminals 31₂₁ and 31₂₂ of the tuner IC31. The tuner IC31 amplifies the intermediate frequency signal to a predetermined level by using the intermediate frequency amplifier circuit and outputs the amplified intermediate frequency signal from the intermediate frequency signal output terminals 31₁₀ and 31₁₁. Subsequently, the second intermediate frequency tuning circuit 46 removes unnecessary frequency components from the intermediate frequency signal and thereafter supplies the so-processed signal to the intermediate frequency signal port 32g.

When the tuner wiring board 32 with the tuner IC31 built therein is configured in the already-known UHF-VHF tuner, the circuits similar in function to each other are collectively disposed on the tuner wiring board 32 wherever possible. Further, the wires or interconnections used to connect between the respective terminals 31₁ through 31₃₂ of the tuner IC31 are set as short as possible and are laid out and configured so as not to intersect wherever possible. However, since the tuner IC31 is configured such that the VHF signal input terminal 31₃₀ and the UHF signal input terminals 31₃₁ and 31₃₂ are drawn or led out in an adjacent state and the UHF selection terminal 31₂₃, the FM trap selection terminal 31₂₄ and the VHF band selection terminals 31₂₅ and 31₂₆ are drawn or led out in a state of adjoining each other in the same manner, a control signal wire or interconnection for electrically connecting the UHF selection terminal 31₂₃ and the UHF signal amplifier circuit 35 will intersect high-frequency signal wires or interconnections for electrically connecting the UHF signal double-tuned circuit 36 and the UHF signal input terminals 31₃₁ and 31₃₂ and a high-frequency signal wire or interconnection for electrically connecting the VHF signal double-tuned circuit 40 and the VHF signal input terminal 31₃₀. In this case, a problem arises in that since each high-frequency signal interconnection is a high-impedance type line, whereas the control signal interconnection is a low-impedance type line, stray capacitance is produced at an intersecting point when both wires intersect each other and thereby some of a high-frequency signal transmitted through each high-frequency signal interconnection leaks to the control signal wire through the stray capacitance to thereby reduce the level of the high-frequency signal supplied to the frequency mixer circuit, and various interference signals and leak voltage components overlaying the control signal wire are transmitted via the stray capacitance to each high-frequency signal wire, where they are mixed into the high-frequency signal and outputted as noise.

With the foregoing problems in view, an object of the present invention is to provide an IC suitable for use in a tuner, wherein when the tuner IC is built in a tuner wiring board to construct the tuner wiring board, the positions at which respective terminals are drawn or led out, are set so as to avoid the intersection of high-frequency signal wires and a control signal wire.

In order to achieve the above object, an IC suitable for use in a tuner, according to the present invention is provided with first means for integrally placing respective major circuit portions in a frequency mixer circuit, a local oscillator circuit, a phase locked loop and an intermediate frequency amplifier circuit within one package and leading out a UHF selection terminal, UHF signal input terminals, a VHF signal input terminal and a high-frequency ground terminal to one end of the package, which is located on the side of the long side thereof, in this order.

Further, in order to achieve the above object, the tuner IC according to the present invention is provided with second means for leading out frequency mixed signal output terminals, VHF band selection terminals, a power terminal and intermediate frequency signal input terminals following the high-frequency ground terminal of the first means to one end of the package in this order.

According to the first means, when the tuner IC is incorporated in a tuner wiring board, a control signal wire electrically connected to the UHF selection terminal no intersects high-frequency signal wires electrically connected between the output of a UHF signal circuit portion or unit and the UHF signal input terminals of the tuner IC, and a high-frequency signal wire electrically connected between the output of a VHF signal circuit portion or unit and the VHF signal input terminal of the tuner IC.

Further, according to the second means, when the tuner IC is assembled into the tuner wiring board, the control signal wire electrically connected to the UHF selection terminal no intersects intermediate frequency signal wires electrically connected between the inputs of an intermediate frequency circuit unit and mixer output terminals of the tuner IC and intermediate frequency signal wires electrically connected between the outputs of the intermediate frequency circuit unit and intermediate frequency signal input terminals of the tuner IC.

While the specification concludes with claims particularly pointing out and distinctly claiming the subject matter which is regarded as the invention, it is believed that the invention, the objects and features of the invention and further objects, features and advantages thereof will be better understood from the following description taken in connection with the accompanying drawings in which:
FIG. 1 is a plan view showing a configuration of one embodiment of an IC suitable for use in a tuner, according to the present invention;
FIG. 2 is a plan view illustrating one example of a layout of a UHF-VHF tuner using the tuner IC shown in FIG. 1;
FIG. 3 is a plan view depicting one example of a configuration of a known IC for a tuner; and
FIG. 4 is a plan view showing one example of a layout of a UHF-VHF tuner using the tuner IC shown in FIG. 3.

### DETAILED DESCRIPTION OF THE PREFERRED EMBODIMENTS

An IC suitable for use in a tuner, according to a preferred embodiment of the present invention is one of the type wherein respective major circuit portions in a frequency mixer circuit, a local oscillator circuit, a phase locked loop and an intermediate frequency amplifier circuit are integrally placed within one package, and a UHF change-over or selection terminal, UHF signal input terminals, a VHF signal input terminal and a high-frequency earth or ground terminal are drawn or led out to one end of the package, which is located on the side of the long side thereof, in this order.

In the preferred example of the above embodiment of the present invention, the tuner IC is one wherein frequency mixed signal output terminals, VHF band selection terminals, a power terminal, intermediate frequency signal input terminals following the high-frequency ground terminal are drawn or led out to one end of the package in this order.

According to an embodiment of the present invention, the terminals, which are drawn or led out to one end of the package of the tuner IC, are placed in order of the UHF selection terminal, UHF signal input terminals, VHF signal input terminal and high-frequency ground terminal. Therefore, when the tuner IC is built in a tuner wiring board, a control signal interconnection or wire for electrically connecting a UHF signal amplifier circuit and the UHF selection terminal of the tuner IC no intersects high-frequency signal wires or interconnections for electrically connecting the outputs of a UHF signal circuit unit and the UHF signal input terminals of the tuner IC and a high-frequency signal wire or interconnection for electrically connecting the output of a VHF signal circuit unit and the VHF signal input terminal of the tuner IC. Further, a reduction in the level of a high-frequency signal due to the leakage of a signal from each high-frequency signal interconnection to the control signal interconnection, and the transmission of an interference signal from the control signal interconnection to each high-frequency signal interconnection, based on the intersection of the high-frequency signal interconnections and the control signal interconnection, are no longer made. Thus, a UHF-VHF tuner is obtained which is capable of normally holding a satisfactory receiving state.

Further, according to the preferred example of the embodiment of the present invention, the terminals drawn or led out to one end of the package of the tuner IC, which is located on the side of the long side thereof, are placed in order of the frequency mixed signal output terminals, VHF band selection terminals, power terminal, intermediate frequency signal input terminals following the high-frequency ground terminal. Therefore, when the tuner IC is assembled into a tuner wiring board, the control signal interconnection or wire for electrically connecting the UHF signal amplifier circuit and the UHF selection terminal of the tuner IC no intersects intermediate frequency signal interconnections or wires for electrically connecting the inputs of an intermediate frequency circuit unit and mixer output terminals of the tuner IC and intermediate frequency signal interconnections or wires for electrically connecting the outputs of the intermediate frequency circuit unit and intermediate frequency signal input terminals of the tuner IC. Further, a reduction in the level of an intermediate frequency signal due to the leakage of a signal from each intermediate frequency signal interconnection to the control signal interconnection, and the transmission of an interference signal from the control signal interconnection to each intermediate frequency signal interconnection, based on the intersection of the intermediate frequency signal interconnections and the control signal interconnection, are no longer made. Thus, a UHF-VHF tuner is obtained which is capable of normally maintaining a satisfactory receiving state.

An embodiment of the present invention will hereinafter be described with reference to the accompanying drawings.

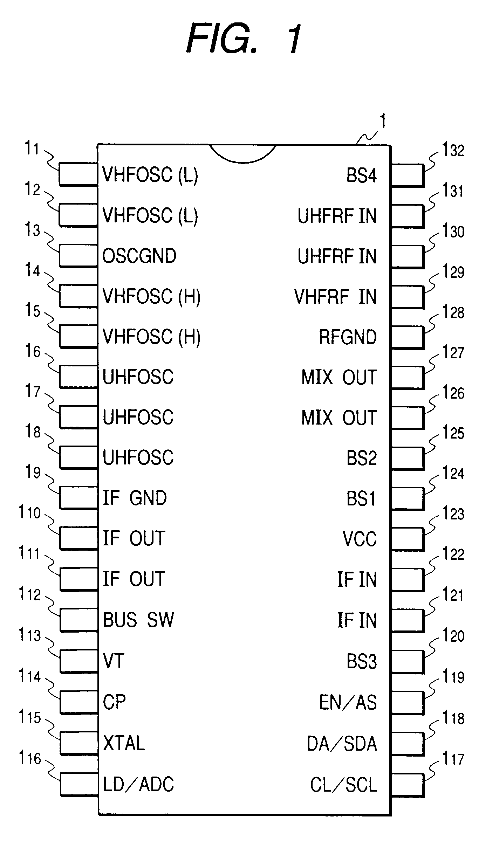

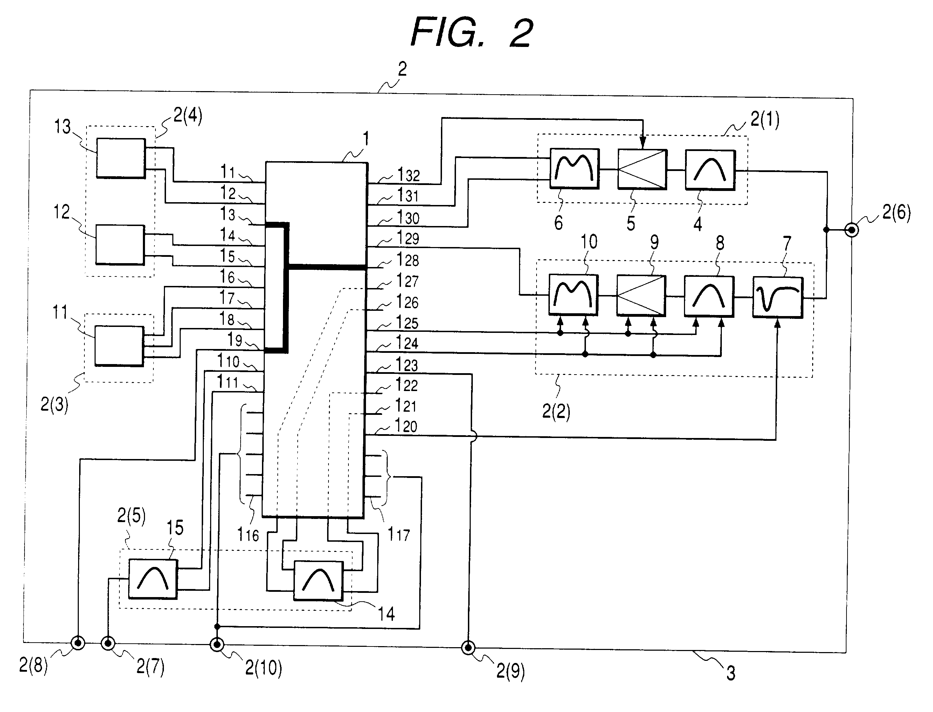

FIG. 1 is a plan view showing a configuration of one embodiment of an IC suitable for use in a tuner, according to the present invention. FIG. 2 is a plan view illustrating one example of a layout of a UHF-VHF tuner using the tuner IC illustrated in FIG. 1.

As shown in FIG. 1, the tuner IC1 according to the present embodiment is equivalent to one wherein respective major circuit portions (corresponding to integrable circuit portions) in a frequency mixer circuit, a local oscillator circuit, a phase locked loop (PLL) and an intermediate frequency amplifier circuit are integrally placed within one package. The tuner IC1 is shaped in the form of a rectangle. Sixteen terminals (connecting pins) 1₁ through 1₁₆ are drawn or led out to one end of the tuner IC1, which is located on the side of the long side thereof. Similarly, sixteen terminals (connecting pins) 1₁₇ through 1₃₂ are drawn or led out to the other end of the tuner IC1, which is located on the side of the long side thereof. Of these terminals 1₁ through 1₁₆ and 1₁₇ through 1₃₂, the terminals 1₁ and 1₂ are VHF low-band local oscillator terminals (VHF OSC(L)), the terminal 1₃ is a local oscillator ground terminal (OSC GND), the terminals 1₄ and 1₅ are VHF high-band local oscillator terminals (VHF OSC(H)), the terminals 1₆, 1₇ and 1₈ are UHF local oscillator terminals (UHF OSC), the terminal 1₉ is an intermediate frequency ground terminal (IF GND), the terminals 1₁₀ and 1₁₁ are intermediate frequency signal output terminals (IF OUT), and the terminals 1₁₂ through 1₁₉ are respectively PLL data terminals (BUS SW, VT, CP, XTAL, LD/ADC, CL/SCL, DA/SDA and EN/AS). Further, the terminal 1₂₀ is an FM trap selection terminal (BS3), the terminals 1₂₁ and 1₂₂ are intermediate frequency signal input terminals (IF IN), the terminal 1₂₃ is a power terminal (Vcc), the terminal 1₂₄ is a VHF high-band selection terminal (BS1), the terminal 1₂₅ is a VHF low-band selection terminal (BS2), the terminals 1₂₆ and 1₂₇ are mixer output terminals (MIX OUT), the terminal 1₂₈ is a high-frequency ground terminal (RF GND), the terminal 1₂₉ is a VHF signal input terminal (VHF RF IN), the terminals 1₃₀ and 1₃₁ are UHF signal input terminals (UHF RF IN), and the terminal 1₃₂ is a UHF selection terminal (BS4).

As shown in FIG. 2, a tuner wiring board 2 is stored and placed within an enclosure or package 3. The tuner wiring board 2 is one wherein the tuner IC1 is built therein and non-integrated circuit portions in a high-frequency circuit portion or unit, a frequency mixer circuit, a local oscillator circuit, a PLL and an intermediate frequency amplifier circuit, e.g., circuit portions or units including inductors, capacitors, etc. are disposed around the tuner IC1. Namely, a UHF signal circuit unit 2a comprised of a UHF signal antenna tuning circuit 4, a UHF signal amplifier circuit 5 and a UHF signal double-tuned circuit 6, a VHF signal circuit unit 2b comprised of an FM signal trap circuit 7, a VHF signal antenna tuning circuit 8, a VHF signal amplifier circuit 9 and a VHF signal double-tuned circuit 10, a UHF local oscillator circuit unit 2c comprised of a UHF local oscillator circuit 11, a VHF local oscillator circuit unit 2d comprised of a VHF high-band local oscillator circuit 12 and a VHF low-band local oscillator circuit 13, and an intermediate frequency signal circuit unit 2e comprised of a first intermediate frequency tuning circuit 14 and a second intermediate frequency tuning circuit 15 are respectively placed in the tuner wiring board 2.

Further, a received signal port 2f supplied with received signals delivered from an antenna (not shown), an intermediate frequency signal port 2g for outputting an intermediate frequency signal therefrom, a ground port 2h electrically connected to ground, a power supply port 2i supplied with a power supply voltage, and a PLL data port 2j for exchanging various data between the PLL in the tuner IC1 and an external microcomputer (not shown) are drawn or led out to the periphery of the tuner wiring board 2 and placed therearound.

In the tuner IC1, the VHF low-band local oscillator terminals 1₁ and 1₂ are electrically connected to the VHF low-band local oscillator circuit 13, and the VHF high-band local oscillator terminals 1₄ and 1₅ are electrically connected to the VHF high-band local oscillator circuit 12. The UHF local oscillator terminals 1₆, 1₇ and 1₈ are electrically connected to the UHF local oscillator circuit 11, and the local oscillator ground terminal 1₃, the intermediate frequency ground terminal 1₉ and the high-frequency ground terminal 1₂₈ are electrically interconnected with each other within the tuner IC1 and electrically connected to the ground port 2h. The intermediate frequency signal output terminals 1₁₀ and 1₁₁ are electrically connected to the inputs of the second intermediate frequency tuning circuit 15 and the output of the second intermediate frequency tuning circuit 15 is electrically connected to the intermediate frequency signal port 2g. The respective PLL data terminals 1₁₂ through 1₁₉ are electrically connected to the PLL data port 2j separately. Only one PLL data port 2j is illustrated in FIG. 2. The FM trap selection terminal 1₂₀ is electrically connected to the FM signal trap circuit 7, and the intermediate frequency signal input terminals 1₂₁ and 1₂₂ pass through the side under the tuner IC1 so as to be connected to the outputs of the first intermediate frequency tuning circuit 14. The power terminal 1₂₃ is electrically connected to the power supply port 2i. The VHF high-band selection terminal 1₂₄ and the VHF low-band selection terminal 1₂₅ are respectively electrically connected to the VHF signal antenna tuning circuit 8, the VHF signal amplifier circuit 9 and the VHF signal double-tuned circuit 10 in isolation. The mixer output terminals 1₂₆ and 1₂₇ pass through the side under the tuner IC1 so as to be electrically connected to the inputs of the first intermediate frequency tuning circuit 14, and the VHF signal input terminal 1₂₉ is electrically connected to the output of the VHF signal double-tuned circuit 10. The UHF signal input terminals 1₃₀ and 1₃₁ are electrically connected to the outputs of the UHF signal double-tuned circuit 6, and the UHF selection terminal 1₃₂ is electrically connected to the UHF signal amplifier circuit 5.

Further, the input of the UHF signal antenna tuning circuit 4 is electrically connected to the received signal port 2f and the output thereof is electrically connected to the input of the UHF signal amplifier circuit 5, respectively. The output of the UHF signal amplifier circuit 5 is electrically connected to the input of the UHF signal double-tuned circuit 6. The input of the FM signal trap circuit 7 is electrically connected to the received signal port 2f and the output thereof is electrically connected to the input of the VHF signal antenna tuning circuit 8, respectively. The output of the VHF signal antenna tuning circuit 8 is electrically connected to the input of the VHF signal amplifier circuit 9. The output of the VHF signal amplifier circuit 9 is electrically connected to the input of the VHF signal double-tuned circuit 10.

The UHF-VHF tuner according to the present embodiment, which has been constructed as described above, is activated as follows:

When the UHF-VHF tuner is first selected so as to receive a UHF signal, a positive voltage is outputted from the UHF selection terminal 1₃₂ of the tuner IC1 and thereafter supplied to the UHF signal amplifier circuit 5, so that the UHF signal amplifier circuit 5 is brought to an operating state. At this time, the UHF signal antenna tuning circuit 4 selects a UHF signal out of the received signals supplied to the received signal port 2f. The selected UHF signal is amplified by the UHF signal amplifier circuit 5 and the UHF signal double-tuned circuit 6 selects a signal corresponding to or for a desired channel in the UHF signal and supplies the signal to the UHF signal input terminals 1₃₀ and 1₃₁. The tuner IC1 frequency-mixes the supplied signal for the desired channel and a local oscillation signal generated from a UHF local oscillator by the frequency mixer and outputs the mixed signal from the mixer output terminals 1₂₆ and 1₂₇. Next, the first intermediate frequency tuning circuit 14 selects an intermediate frequency signal from the frequency-mixed signal and supplies it to the intermediate frequency signal input terminals 1₂₁ and 1₂₂ of the tuner IC1. At this time, the tuner IC1 amplifies the intermediate frequency signal to a predetermined level by the intermediate frequency amplifier circuit and outputs the amplified intermediate frequency signal from the intermediate frequency signal output terminals 1₁₀ and 1₁₁. Subsequently, the second intermediate frequency tuning circuit 15 removes unnecessary frequency components from the intermediate frequency signal and thereafter supplies the so-processed signal to the intermediate frequency signal port 2g.

On the other hand, when the UHF-VHF tuner is selected so as to receive a VHF high-band signal, a positive voltage is outputted from the VHF high-band selection terminal 1₂₄ of the tuner IC1. The positive voltage is supplied to the VHF signal amplifier circuit 9 so that the VHF signal amplifier circuit 9 is brought to an operating state. Further, the positive voltage is supplied to the VHF signal antenna tuning circuit 8 and the VHF signal double-tuned circuit 10 to change these tuning circuits 8 and 10 to a VHF high band, thereby bringing them to a state capable of receiving the VHF high-band signal. At this time, each received signal supplied to the received signal port 2f is transmitted through the FM signal trap circuit 7 substantially set to a non-loss state. The VHF signal antenna tuning circuit 8 selects a VHF high-band signal and the VHF signal amplifier circuit 9 amplifies the selected VHF high-band signal. The VHF signal double-tuned circuit 10 selects a signal for a desired channel in the VHF high-band signal and supplies it to the VHF signal input terminal 1₂₉ of the tuner IC1. The tuner IC1 frequency-mixes the supplied signal for the desired channel and a local oscillation signal generated from a VHF high-band local oscillator by the frequency mixer and outputs the frequency-mixed signal from the mixer output terminals 1₂₆ and 1₂₇. Next, the first intermediate frequency tuning circuit 14 selects an intermediate frequency signal from the mixed signal and supplies the selected intermediate frequency signal to the intermediate frequency signal input terminals 1₂₁ and 1₂₂ of the tuner IC1. At this time, the tuner IC amplifies the intermediate frequency signal to a predetermined level by the intermediate frequency amplifier circuit and outputs the amplified intermediate frequency signal from the intermediate frequency signal output terminals 1₁₀ and 1₁₁. Consecutively, the second intermediate frequency tuning circuit 15 removes unnecessary frequency components from the intermediate frequency signal and thereafter supplies the so-processed signal to the intermediate frequency signal port 2g.

Further, when the UHF-VHF tuner is selected so as to receive a VHF low-band signal, a positive voltage is outputted from the VHF low-band selection terminal 1₂₅ of the tuner IC1. The positive voltage is supplied to the VHF signal amplifier circuit 9 so that the VHF signal amplifier circuit 9 is brought to an operating state. Further, the positive voltage is supplied to the VHF signal antenna tuning circuit 8 and the VHF signal double-tuned circuit 10 to change these circuits 8 and 10 to a VHF low band, thereby bringing them to a state capable of receiving the VHF low-band signal. Only when the tuner IC1 now selects channels of VHF low-band signal channels, which are adjacent to an FM-radio broadcast carrier frequency and undergo interference of its carrier frequency, e.g., 6 channels (called "non-interfered channels" even in the present embodiment) in the VHF low band for US television broadcasting, a positive voltage is outputted from the FM trap section terminal 1₂₀. The positive voltage is supplied to the FM signal trap circuit 7 to bring the FM signal trap circuit 7 into an operating state, thereby serving so as to attenuate FM-radio broadcast carrier frequency components. Therefore, when the respective channels other than the non-interfered channels in the VHF low-band signal channels are received, the VHF low-band signal supplied to the received signal port 2f is transmitted through the FM signal trap circuit 7 substantially set to the non-loss state and is selected by the VHF signal antenna tuning circuit 8. The selected VHF low-band signal is amplified by the VHF signal amplifier circuit 9, and a signal for a desired channel in the VHF low-band signal is selected by the VHF signal double-tuned circuit 10 and supplied to the VHF signal input terminal 1₂₉ of the tuner IC1. On the other hand, when the non-interfered channels are received, the FM signal trap circuit 7 removes interference frequency components from the non-interfered channel signal supplied to the received signal port 2f. Thereafter, the VHF signal antenna tuning circuit 8 selects a VHF low-band signal and the VHF signal amplifier circuit 9 amplifies the selected VHF low-band signal. Further, the VHF signal double-tuned circuit 10 selects a signal for a non-interfered channel in the VHF low-band signal and supplies the selected signal to the VHF signal input terminal 1₂₉ of the tuner IC1. Even in this case, the tuner IC1 frequency-mixes the supplied signal for the desired channel and a local oscillation signal generated from the VHF high-band local oscillator by the frequency mixer and outputs the mixed signal from the mixer output terminals 1₂₆ and 1₂₇. Next, the first intermediate frequency tuning circuit 14 selects an intermediate frequency signal from the frequency-mixed signal and supplies the selected intermediate frequency signal to the intermediate frequency signal input terminals 1₂₁ and 1₂₂ of the tuner IC1. At this time, the tuner IC amplifies the intermediate frequency signal to a predetermined level by using the intermediate frequency amplifier circuit and outputs the amplified intermediate frequency signal from the intermediate frequency signal output terminals 1₁₀ and 1₁₁. Subsequently, the second intermediate frequency tuning circuit 15 removes unnecessary frequency components from the intermediate frequency signal and thereafter supplies the so-processed signal to the intermediate frequency signal port 2g.

In this case, the tuner IC1 according to the present embodiment is constructed so that the UHF selection terminal 1₃₂ is placed at the end of the package, the UHF signal input terminals 1₃₁ and 1₃₀ and VHF signal input terminal 1₂₉ are placed following the UHF selection terminal 1₃₂, and the high-frequency ground terminal 1₂₈ is placed subsequent to them. Therefore, when the tuner IC1 is built in the tuner wiring board 2, and the UHF-VHF tuner is laid out, a low-impedance control signal wire or interconnection for connecting between the UHF selection terminal 1₃₂ and the UHF signal amplifier circuit 5 no intersects any of high-impedance high-frequency signal wires or interconnections for connecting the UHF signal input terminals 1₃₁ and 1₃₀ and the output of the UHF signal double-tuned circuit 6 and high-impedance high-frequency signal wires or interconnections for connecting the VHF signal input terminal 1₂₉ and the output of the VHF signal double-tuned circuit 10. Further, a reduction in the level of a high-frequency signal due to the leakage of a signal from each high-frequency signal interconnection to the control signal interconnection and the transmission of an interference signal from the control signal interconnection to each high-frequency signal interconnection, both of which are based on the intersection of the control signal interconnection and the high-frequency signal interconnections, are not made.

Further, the tuber IC1 according to the present embodiment is constructed so as to dispose the mixer output terminals 1₂₇, 1₂₆, VHF low-band selection terminal 1₂₅, VHF high-band selection terminal 1₂₄, power terminal 1₂₃ and intermediate frequency signal input terminals 1₂₂ and 1₂₁, following the high-frequency ground terminal 1₂₈. Therefore, when the tuner IC1 is built in the tuner wiring board 2 and the UHF-VHF tuner is laid out, the low-impedance control signal interconnection for connecting between the UHF selection terminal 1₃₂ and the UHF signal amplifier circuit 5 no intersects high-impedance intermediate frequency signal wires or interconnections for connecting the mixer output terminals 1₂₇ and 1₂₆ and the inputs of the first intermediate frequency tuning circuit 14 and high-impedance intermediate frequency signal wires or interconnections for connecting the intermediate frequency signal input terminals 1₂₂ and 1₂₁ and the outputs of the first intermediate frequency tuning circuit 14. Further, a reduction in the level of an intermediate frequency signal due to the leakage of a signal from each intermediate frequency signal interconnection to d.c. wiring and the transmission of an interference signal from the control signal interconnection to each intermediate frequency signal interconnection, both of which are based on the interconnection of the control signal interconnection and each intermediate frequency signal interconnection, are not made.

According to the present invention as has been described above, terminals drawn or led out to one end of a tuner IC, which is located on the side of the long side thereof, are placed in order of a UHF selection terminal, UHF signal input terminals, a VHF signal input terminal and a high-frequency ground terminal. Therefore, when the tuner IC is built in a tuner wiring board, a control signal wire for electrically connecting a UHF signal amplifier circuit and the UHF selection terminal of the tuner IC no intersects high-frequency signal wires for electrically connecting the outputs of a UHF signal circuit unit and the UHF signal input terminals of the tuner IC and a high-frequency signal wire for electrically connecting the output of a VHF signal circuit unit and the VHF signal input terminal of the tuner IC. Further, a reduction in the level of a high-frequency signal due to the leakage of a signal from each high-frequency signal wire to the control signal wire, and the transmission of an interference signal from the control signal wire to each high-frequency signal wire, based on the intersection of the high-frequency signal wires and the control signal wire, are no longer made. Thus, an advantageous effect can be brought about in that a UHF-VHF tuner is obtained which is capable of normally holding a satisfactory receiving state.

Further, according to the present invention, terminals drawn or led out to one end of a tuner IC, which is located on the side of the long side thereof, are placed in order of frequency mixed signal output terminals, VHF band selection terminals, power terminal, intermediate frequency signal input terminals following the high-frequency ground terminal. Therefore, when the tuner IC is assembled into a tuner wiring board, the control signal interconnection for electrically connecting the UHF signal amplifier circuit and the UHF selection terminal of the tuner IC no intersects intermediate frequency signal interconnections or wires for electrically connecting the inputs of an intermediate frequency circuit unit and mixer output terminals of the tuner IC and intermediate frequency signal interconnections or wires for electrically connecting the outputs of the intermediate frequency circuit unit and intermediate frequency signal input terminals of the tuner IC. Further, a reduction in the level of an intermediate frequency signal due to the leakage of a signal from each intermediate frequency signal wire to the control signal wire, and the transmission of an interference signal from the control signal wire to each intermediate frequency signal wire, based on the intersection of the intermediate frequency signal wires and the control signal wire, are no longer made. Thus, an advantageous effect can be brought about in that a UHF-VHF tuner is obtained which is capable of always maintaining a satisfactory receiving state.

While the present invention has been described with reference to the illustrative embodiment, this description is not intended to be construed in a limiting sense. Various modifications of the illustrative embodiment will be apparent to those skilled in the art on reference to this description. It is therefore contemplated that the appended claims will cover any such modifications or embodiments as fall within the true scope of the invention.

## Claims

1. An IC suitable for use in a tuner, comprising:
major circuit portions in a frequency mixer circuit, a local oscillator circuit, a phase locked loop and an intermediate frequency amplifier circuit;
said major circuit portions being integrally placed within one package, said package having one longer side, to which a UHF selection terminal, UHF signal input terminals, a VHF signal input terminal and a high-frequency ground terminal are led out in this order.

2. The tuner IC according to claim 1, wherein frequency mixed signal output terminals, VHF band selection terminals, a power terminal and intermediate frequency signal input terminals following said high-frequency ground terminal are led out to said one longer side of said package in this order.
